# EUROPEAN PATENT APPLICATION

(11) **EP 4 597 126 A1**
(43) Date of publication of application: **06.08.2025**
(21) Application number: 24155699.2
(22) Date of filing: 05.02.2024
(51) Int. Cl.: G01R 29/26

(54) **NOISE TEST SYSTEM**

(71) Applicant: Koninklijke Philips N.V., 5656 AG Eindhoven (NL)
(72) Inventor: FINDEKLEE, Christian, Eindhoven (NL); VERNICKEL, Peter, Eindhoven (NL); LEUSSLER, Christoph Günther, 5656AG Eindhoven (NL)
(74) Representative: Philips Intellectual Property & Standards

(57) **Abstract**

Disclosed herein is a system (100, 900, 1000) and a method of determining noise parameters (128) of an amplifier or receiver device under test (DUT). The system comprises a computational system (104) configured to perform a method comprising: receiving (200) calibration data (124) that comprises multiple noise power measurements descriptive of the output of the DUT corresponding to a predetermined set of complex noise input signals (126); and determining (202) a set of linear noise parameters of the DUT by fitting the multiple noise power measurements and the corresponding set of complex noise input signals to a circuit model (122, 700, 800) of the DUT.

## Description

### TECHNICAL FIELD

The invention relates to the determination of a set of linear noise parameters for an amplifier, in particular determining the set of linear noise parameters for a preamplifier used in magnetic resonance imaging.

### BACKGROUND

In magnetic resonance imaging, extremely low noise amplifiers are used to pick up signals down to the thermal noise level. Often, for magnetic resonance imaging preamplifiers are configured for using the so-called preamplifier decoupling technique, where the preamplifier is intentionally mismatched (with respect to the power transfer) to an antenna element to avoid coupling between multiple antenna elements. The use of the preamplifier decoupling technique may make it challenging to characterize the noise of the preamplifier because the noise measurements may be highly dependent upon the input impedance.

United States patent application US2016124032A1 discloses systems and methods of measuring and determining noise parameters. An exemplary method measures noise data and determines element values of a device noise model for a device under test (DUT), using a test system including an impedance tuner coupled to an input of the DUT for presenting a controllable variable impedance to the DUT and a noise receiver coupled to an output of the DUT. Noise data is measured as a function of at least one measurement parameter. The measured data includes raw noise data read from the noise receiver and is used to determine element values of the device noise model. The system may include a database of device models.

### SUMMARY

The invention provides for a noise test system, a computer program, and a method of determining a set of linear noise parameters of an amplifier in the independent claims. Embodiments are given in the dependent claims.

In one aspect the invention provides for a noise test system for determining a set of linear noise parameters of an amplifier. The noise test system comprises a memory storing machine-executable instructions. The noise test system further comprises a computational system. Execution of the machine-executable instructions causes the computational system to receive calibration data. The calibration data comprises multiple noise power measurements descriptive of an output of the amplifier corresponding to a predetermined set of complex noise input signals. Execution of the machine-executable instructions further causes the computational system to determine the set of linear noise parameters of the amplifier by fitting the multiple noise power measurements and the corresponding set of complex noise signals to a circuit model of the amplifier.

In another aspect, the invention provides for a computer program comprising machine-executable instructions for execution by a computational system configured to control a noise test system according to an embodiment.

In yet a further aspect, the invention provides for a method of determining a set of linear noise parameters of an amplifier. The method comprises receiving calibration data. The calibration data comprises multiple noise power measurements descriptive of an output of the linear amplifier corresponding to a predetermined set of complex noise input signals. The method further comprises determining the set of linear noise parameters of the amplifier by fitting the multiple noise power measurements and the corresponding set of complex noise input signals to a circuit model of the amplifier.

### BRIEF DESCRIPTION OF THE DRAWINGS

In the following preferred embodiments of the invention will be described, by way of example only, and with reference to the drawings in which:
Fig. 1 illustrates an example of a noise test system.
Fig. 2 shows a flow chart which illustrates a method of using the noise test system of Fig. 1.
Fig. 3 illustrates a further example of a noise test system.
Fig. 4 shows a flow chart which illustrates a method of using the system of Fig. 3.
Fig. 5 illustrates an example of a set of calibrated matching networks and a switching network.
Fig. 6 illustrates a Smith chart showing the (reflection coefficients corresponding to the) complex conjugate input impedance (optimal source impedance for power gain in case *S*_{1,2}=0) and the optimal impedance of an amplifier.
Fig. 7 illustrates an equivalent circuit model of an analog amplifier.
Fig. 8 illustrates a circuit model of a digital amplifier.
Fig. 9 illustrates an analog noise test system.
Fig. 10 illustrates a digital noise test system.

### DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure, unless mutually exclusive. For the sake of brevity, however, the numerous iterations of these combinations will not be described separately. Features described in relation to a system, may be implemented in a computer implemented method and/or in a computer program product, in a corresponding manner.

Like numbered elements in these figures are either equivalent elements or perform the same function. Elements which have been discussed previously will not necessarily be discussed in later figures if the function is equivalent.

In an example, a noise test system is configured for determining a set of linear noise parameters of an amplifier. The noise test system comprises a memory storing machine-executable instructions. The noise test system further comprises a computational system. The computational system may refer to one or more computational systems or computing cores that may be located at one or more locations. Execution of the machine-executable instructions causes the computational system to receive calibration data. The calibration data comprises multiple noise power measurements descriptive of an output of the amplifier corresponding to a predetermined set of complex noise input signals.

In further examples, the calibration data could comprise a set of noise power values measured for defined input impedances at defined noise temperatures. In some examples, it could comprise additional measurements to characterize the noise of the measurement setup. This may for example be done by connecting the noise source directly to the measurement receiver, thus, without the DUT.

Execution of the machine-executable instructions further causes the computational system to determine the set of linear noise parameters of the amplifier by fitting the multiple noise power measurements and the corresponding set of complex noise input signals to a circuit model of the amplifier. The circuit model of the amplifier has various parameters which are adjusted such that the simulated/calculated noise power levels at the output for the predetermined set of complex noise input signals match the multiple noise power measurements. This example may be beneficial because it may provide for an improved means of determining the set of linear noise parameters of an amplifier.

Due to the very low noise of some amplifiers, the exact measurement of the noise parameters is extremely challenging, especially when the input reflection is very high (as this is typically the case in magnetic resonance imaging (MRI) applications, especially when implementing preamp decoupling) while the signal properties, in particular the input impedance and the gain, can be measured very easily and accurately with a vector network analyzer (VNA). This is because a high input reflection may strongly increase the inaccuracy of the traditionally used methods like the Y-factor method. The adjustment of a circuit model to fit the multiple noise power measurements to the corresponding set of complex noise input signals may provide a means of accurately measuring the noise parameters.

Another, often underestimated issue is that preamplifiers for MRI are designed to have a highly reflective input which enables the so-called preamplifier decoupling technique. Any noise measurement then becomes very sensitive for the source impedance which cannot be guaranteed to be stable, especially when changing the effective noise temperature of a calibrated source. Due to the strong mismatch between source and receiver input, any small change has a huge impact which makes traditional Y-factor measurements very inaccurate.

Examples may overcome the drawbacks of the traditional Y-factor measurement by considering the noise source impedance variations. In addition, the noise figure is not determined at any single source impedance. Instead, the temperature-dependent source impedance changes are taken into account when deriving the noise parameters from all the raw data by fitting to a circuit model. The method is not limited to analog receivers (i.e. preamps) since the output may be a digital data stream as well.

In another example the circuit model, which in examples may be a low noise (pre) amplifier (LNA), comprises a first reactance. The circuit model further comprises a set of noise sources. The set of noise sources comprises a voltage noise source and a current noise source. The voltage noise source and the current noise source may possibly be correlated. The correlation between the voltage noise source and the current noise source means that when one is producing noise the other is producing a to some defined extent corresponding noise. The first reactance is connected in series between an input of the circuit model and the voltage noise source. The circuit model further comprises an amplifier model. The amplifier model comprises a real valued input impedance. The amplifier model optionally comprises an adjustable gain. In some instances, the gain of the amplifier model may be fixed and in other examples it may be adjustable. The circuit model further comprises a second reactance. The second reactance is connected in series between the voltage noise source and an input of the amplifier model. The current noise source is connected between a ground and the second reactance where the voltage noise source is connected to the second reactance. An output of the amplifier model is connected to an output of the circuit model. This example may be beneficial because it provides a means of varying all the linear noise parameters of a pre-amplifier or LNA in combination with a variable input impedance and gain.

In another example, determining the set of linear noise parameters comprises adjusting values of the first reactance, the second reactance, a noise level of the voltage noise source, a noise level of the current noise source, preferably the correlation between the voltage noise source and the current noise source, and preferably a gain of the amplifier model to the corresponding predetermined set of complex noise input signals and measured power levels. This example may be beneficial because the determining of the set of linear noise parameters may be accurately determined by solving the optimization problem to set these values.

In another example, the set of linear noise parameters comprises an optimal source impedance comprising a real and an imaginary part. The imaginary part of the optimal source impedance is equal to the negative first reactance. The real part of the optimal source impedance is calculated by dividing the noise level of the voltage noise source by the noise level of the current noise source. This example may be beneficial because it provides for a means of determining the optimal source impedance, which may define two of the four linear noise parameters. The optimal source impedance (related to so-called noise matching) is an impedance for which the noise is minimized, and it is different from the optimal matching impedance for maximized power transfer (related to so-called power matching). In magnetic resonance imaging it is common that multiple antenna elements will be used simultaneously. A difficulty is that there may be (residual) coupling between the various antenna elements. To minimize coupling between the antenna elements, they are typically connected in a power-mismatched state to their pre-amplifier. This preamp decoupling technique basically makes use of the difference between noise- and power matching. Determining the optimal source impedance therefore may enable better configuration of a magnetic resonance imaging system which enables the minimization of noise and irrespective of the coupling between antenna elements, resulting in higher quality magnetic resonance images.

In another example, the set of linear noise parameters comprises a complex optimal source impedance (with two degrees of freedom), a minimal noise figure, and a Lange-N parameter. The determination of the set of linear noise parameters is beneficial because it provides a characterization of the noise in an amplifier or pre-amplifier for any given source impedance. In other examples, the set of linear noise parameters may be formulated using different representations.

In another example, the predetermined set of noise input signals is based on a set of noise signals generated by predetermined combinations of a set of calibrated matching networks and a calibrated noise source connected in series.

In another example, the noise source is configured to operate at a predefined set of temperatures (typically just two). This may be beneficial because the noise characteristics of a noise source change with temperature. Typical commercial noise sources may be implemented having two temperatures and are designed to stay almost perfectly at 50 ohms impedance. However, a small step in that impedance may have a huge impact on accuracy and it may therefore be beneficial to be measured and taken into account.

In another example, the noise test system comprises the calibrated noise source. In another example, the noise test system comprises the set of calibrated matching networks.

In another example, the noise test system comprises a measurement device configured to measure the multiple noise power measurements.

In another example, the noise test system further comprises a switching network configured for providing the multiple matching networks during the repeated acquisition of the multiple noise power measurements. The noise test system preferably comprises a temperature control system configured for adjusting the controllable temperature between the predefined set of temperatures or may be used to adjust a controllable environment temperature for multiple components of the noise test system. The temperatures control system may be configured to hold the components of the noise test system at a constant temperature and then have additional controls to vary the temperature of the noise source (the noise spectrum may change with different temperatures). The noise source could for example comprise a temperature sensor. In some examples, there may also be a temperature system for measuring the temperature of the components of the matching network to ensure that they are calibrated or evaluated for a particular temperature. This may have two aspects in some examples. First, the DUT may have stable noise parameters, thus, it may be kept at a constant temperature. Second, the noise level at the input of the DUT may preferably be known. In tests, this was solved by using the calibrated noise levels of the noise source and assuming thermal noise at the measured environment temperature from the matching networks. One can also calculate the noise of the noise source for a given temperature (thus, one doesn't necessarily need to use predefined and calibrated temperatures). One could use a more advanced temperature dependent model instead.

In another example, execution of the machine-executable instructions further causes the computational system to acquire the multiple noise power measurements by repeatedly preferably controlling the temperature control system for adjusting the controllable temperature to one of the predefined set of temperatures. This for example may be to hold the particular noise source or an environmental temperature (DUT and/or matching networks and/or noise source to a chosen temperature. Execution of the machine-executable instructions further causes the computational system to repeatedly control the switching network to attach a different matching network selected from the multiple calibrated matching networks using the switching network. Execution of the machine-executable instructions further causes the computational system to control the measurement device to acquire one of the multiple noise power measurements corresponding to the different matching networks and preferably the one of the predefined set of temperatures. This embodiment may be beneficial because it may provide for an automated means of measuring the set of linear noise parameters.

In another example, the measurement device is configured to receive an analogue signal from the amplifier. In another example, the measurement device is configured to measure one of the multiple noise power measurements. This example may be beneficial because it may provide a means of measuring the parameters of analogue amplifiers.

In another example, the measurement device is configured to receive a digital signal from the amplifier. The measurement device is further configured to calculate a noise spectrum by Fourier transforming the digital signal. The measurement device is further configured to determine one of the multiple noise power measurements from a predetermined portion of the digital noise spectrum. For example, polynomial or other curves could be fit to the noise power spectrum. This embodiment may be beneficial because may provide an effective means of calibrating a digital pre-amplifier.

In another example, there is a method of determining a set of linear noise parameters of an amplifier. The method comprises receiving calibration data. The calibration data comprises multiple noise power measurements descriptive of an output of the amplifier corresponding to a predetermined set of complex noise input signals. The method further comprises determining the set of linear noise parameters of the amplifier by fitting the multiple noise power measurements and the corresponding set of noise input signals to a circuit model of the amplifier.

In another example of the method, the circuit model is as previously described above. There is a first reactance. The circuit model further comprises a set of noise sources. The set of noise sources comprises a voltage noise source and a current noise source. The voltage noise source and the current noise source are preferably correlated. The first reactance is connected in series between the input of the circuit model and the voltage noise source. The circuit model further comprises an amplifier model. The amplifier model comprises a real valued input impedance. The circuit model further comprises a second reactance. The second reactance is connected in series between the voltage noise source and the input of the amplifier model. The current noise source is connected between a ground and the second reactance where the voltage noise source is connected to the second reactance. An output of the amplifier model is connected to an output of the circuit model. The output may for example be an analogue output or a digital output.

In another example, the method comprises determining a set of (linear) model parameters comprising adjustable values of the first reactance, the second reactance, and a noise level of the voltage noise source, a noise level of the current noise source, the correlation between the voltage noise source and the current noise source, and preferably the gain of the amplifier model to fit the corresponding set of noise parameters of the amplifier. The input impedance of the amplifier being tested could be measured using a voltage network analyzer measurement. Besides the optimal noise figure and the Lange-N parameter, the signals. The set of linear noise parameters comprises an optimal source impedance comprising an imaginary part and a real part. The real part of the optimal source impedance is equal to the negative first reactance. The real part of the optimal source impedance is calculated by dividing the noise level of the voltage noise source by the noise level of the current noise source. The amplifier may be a magnetic resonance imaging pre-amplifier. The magnetic resonance imaging system coil assembly comprises a magnetic resonance imaging coil connected to the amplifier via a matching network. The method further comprises adjusting the components of a matching network to optimize for signal to ratio (SNR) e.g., by forming an output impedance of the matching network to provide the optimal source impedance.

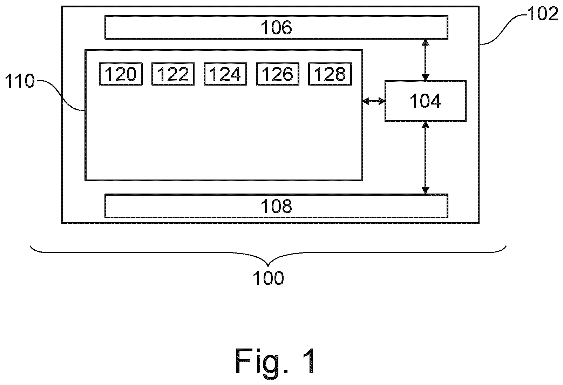

Fig. 1 illustrates an example of a noise test system 100. The noise test system 100 is shown as comprising a computer 102. The computer 102 may represent one or more computers, controllers or computing devices located at one or more locations. The computer 102 is shown as comprising a computational system 104. The computational system 104 may represent one or more computational cores, processors or computational systems located at one or more locations. The computational system 104 is shown as being in communication with an optional hardware interface 106 and an optional user interface 108. The hardware interface 106 may enable the computational system 104 to communicate with and/or control other components of the noise test system 100 if they are present. The user interface 108 may enable an operator to operate and/or control the noise test system 100.

The memory 110 is intended to represent various types of memory which are accessible to the computational system. In some examples, the memory 110 may be a non-transitory storage medium. The memory 110 is shown as comprising or storing machine-executable instructions 120. The machine-executable instructions 120 enable the computational system 104 to operate and control the noise test system 100 as well as to perform various numerical computations and tasks. The memory 110 is further shown as containing a circuit model 122 which is used to model a device under test. Optimization of the circuit model 122 enables the determination of the set of linear noise parameters 128. The memory 110 is shown as storing calibration data 124 and a predetermined set of complex noise signals 126. The predetermined set of complex noise signals 126 represents the signals that are put into the device under test or the amplifier under test and the calibration data 124 are power measurements which are descriptive of the output of the amplifier for a particular complex noise signal. The memory 110 is further shown as storing the set of linear noise parameters 128. By optimizing the circuit model 122 the complex noise signals 126 are fit to the corresponding power measurements in the calibration data 124. The resulting optimized circuit model 122 may then be used to determine the set of linear noise parameters 128.

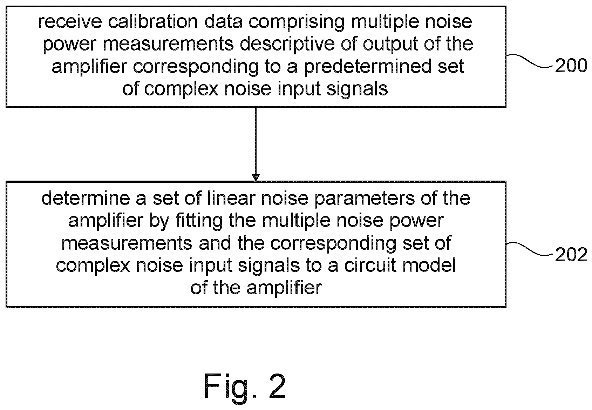

Fig. 2 shows a flowchart which illustrates a method of operating the noise test system 100 of Fig. 1. In step 200 the calibration data 124 is received. As was mentioned before, the calibration data comprises multiple noise power measurements that are descriptive of the output of the amplifier being tested which correspond to a predetermined set of complex noise input signals. In step 202 the set of linear noise parameters of the amplifier are determined by fitting the multiple noise power measurements in the calibration data 124 and the corresponding set of complex noise input signals 126 to the circuit model 122.

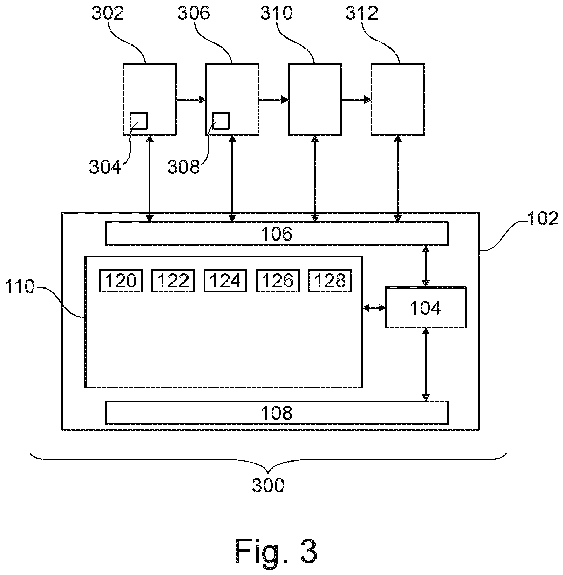

Fig. 3 shows a further example of a noise test system 300. The noise test system of Fig. 3 is shown as additionally comprising a calibrated noise source 302. The calibrated noise source 302 provides a noise source which produces a known spectrum of noise for a given temperature. The calibrated noise source 302 is shown as optionally comprising a thermal control system and/or thermal measurement system 304. This thermal control and/or measurement system 304 may be used for either maintaining a controlled temperature of the calibrated noise source 302 and/or measuring its temperature during measurements. The calibrated noise source 302 is shown as being connected to a set of calibrated matching networks 306. In this example the set of calibrated matching networks 306 may be able to switch automatically between the different matching networks. The set of calibrated matching networks 306 is also shown as optionally containing a thermal control system and/or thermal management system 308 for either maintaining a particular temperature of the set of calibrated matching networks 306 and/or measuring their temperature. The output of the set of calibrated matching networks 306 is shown as being connected to an amplifier 310. The amplifier 310 is the device under test or DUT. This DUT may be also temperature controlled like noise source and matching networks in some examples. Preferably, the temperature is kept constant during the measurement of a set of noise parameters. The temperature dependency can be measured by changing a controlled temperature for each measurement of all the parameters. The DUT may also be placed in a temperature-controlled environment with the matching networks to simplify the setup.

The output of the amplifier 310 is shown as being connected to a measurement device 312. The measurement device is able to make power measurements from the output of the amplifier 310. The output of the amplifier 310 may either be an analogue signal in which case the measurement device is an analogue power meter, or the output of the amplifier is digital and the measurement device 312 receives the digital signal and then creates a power spectrum from which the power measurement is obtained. Some analog power meters may also use a power spectrum calculation to calculate the power for the entire power spectrum or just a portion of the power spectrum.

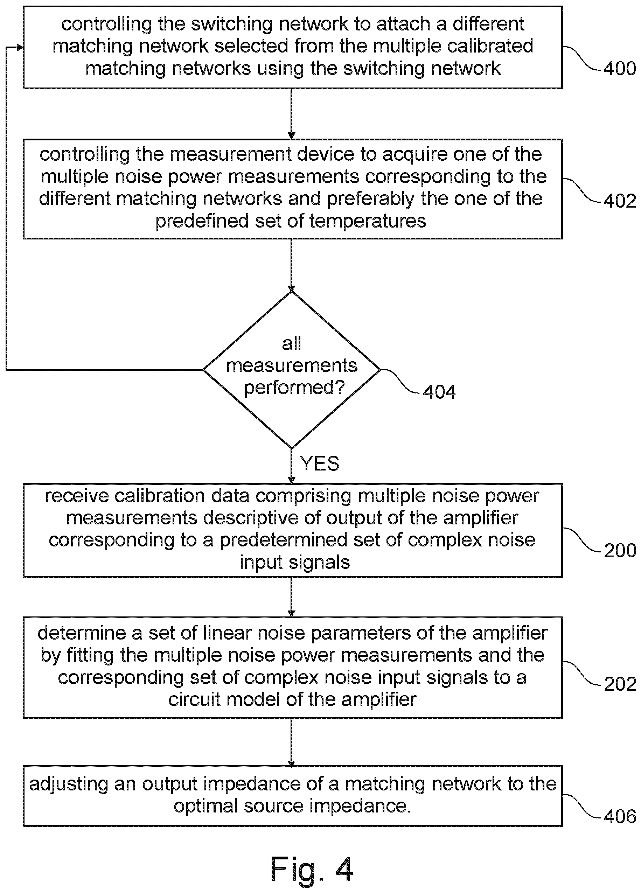

Fig. 4 shows a flowchart of a method of using the noise test system of Fig. 3. In step 400 the switching network is controlled to attach a different matching network selected from the multiple calibrated matching networks 306 using a switching network. In step 402 the measurement device 312 is controlled to acquire one of the multiple noise power measurements corresponding to the different matching networks. In step 404 is a question box. In step 404 the question is whether all measurements are made. If the answer is no, the method returns to step 400 and steps 400 and 402 are repeated until all power measurements are made. After the measurements have been completed the method proceeds to blocks 200 and 202 as was illustrated in Fig. 2. In step 202 the set of linear noise parameters are determined by adjusting various values of the circuit model 122. In optional step 406 the method comprises adjusting an output impedance of a matching network to the optimal source impedance.

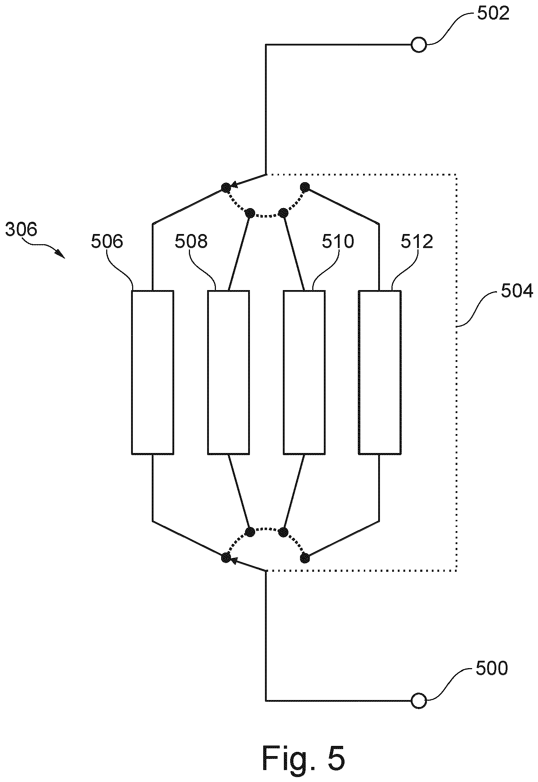

Fig. 5 illustrates an example of a set of calibrated matching networks 306. In this example, the set of matching networks comprises an input 500 and an output 502. Connected to both the input 500 and the output 502 is a switching network 504. This enables automated switching between three different matching networks 506, 508, 510, 512. Using this configuration or a different type or style of switching network 504 the switching between the matching networks 506, 508, 510, 512 can be performed automatically or in an automated fashion for the noise test system 300.

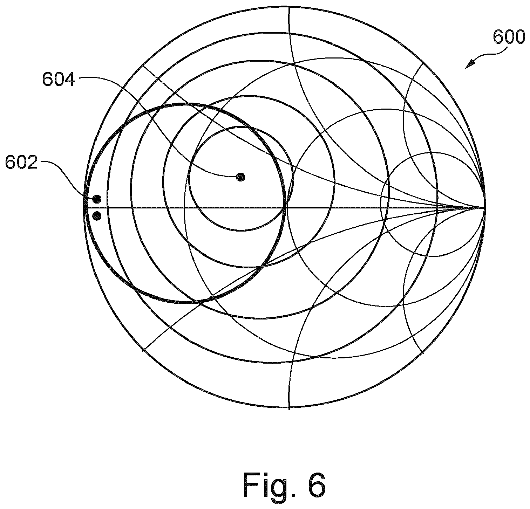

Fig. 6 shows a smith chart 600. The Smith chart 600 shows the optimal reflection coefficient (corresponding to the SNR-optimal impedance) 604 and the complex conjugate input reflection (corresponding to the complex conjugate input impedance) 602 which at the same time represents the power optimized source. For a source providing the complex conjugate input reflection coefficient 602, the gain of the amplifier is maximized (power match). For the optimal impedance 604 the noise of the amplifier is minimized (more precisely, the SNR at the amplifier output is maximized). It is noted that the optimal source reflection coefficient 604 is not providing a power-matched state. This may be particularly beneficial for magnetic resonance imaging because this also helps to prevent coupling between the different antenna elements of a multi-element magnetic resonance antenna (preamp decoupling). The circles around the optimal source reflection 604 show reflections of constant noise figure.

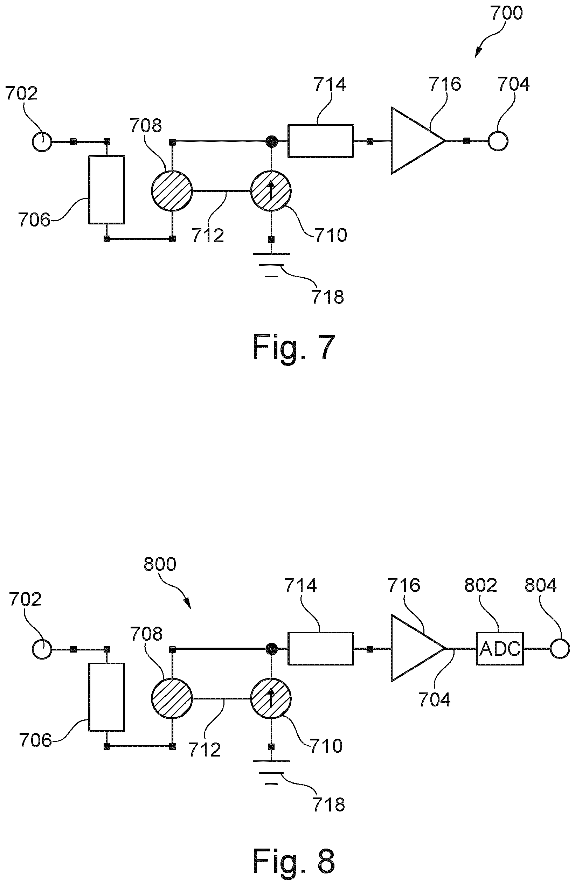

Figs. 7 and 8 illustrate two examples of a circuit model of the amplifier. In Fig. 7, a circuit model of an analogue amplifier 700 is illustrated. The circuit model of the analogue amplifier 700 comprises an analogue input 702 and an analogue output 704. There is a first reactance 706, a voltage noise source 708, a current noise source 710, a second reactance 714, and a (noiseless) amplifier 716. The first reactance 706 is connected between the analogue input 702 and the voltage noise source 708. The voltage noise source is connected between the first reactance 706 and the second reactance 714. The amplifier 716 is connected between the second reactance 714 and the analogue output 704. The current noise source 710 is connected to the connection point of the voltage noise source 708 and the second reactance 714 and ground 718. There is a correlation 712 between the two noise sources 708, 710. The various circuit parameters illustrated in the circuit model of the analogue amplifier 700 can be adjusted to match the predetermined set of complex noise signals 126 and the power measurements in the calibration data 124.

In magnetic resonance imaging, sometimes also digital preamplifiers are used or indirectly given by the complete receive chain, i.e. the LNA together with cables and ADC. Fig. 8 illustrates an example of a circuit model of a digital preamplifier 800 that is very similar to the circuit model 700 except that it additionally comprises an analogue-to-digital converter 802 which outputs a signal on a digital output 804. In this example the analogue output 704 is shown as being fed into the analogue-to-digital converter 802. However, in some examples the functionality of the amplifier 716 may be combined with the analogue-to-digital converter 802.

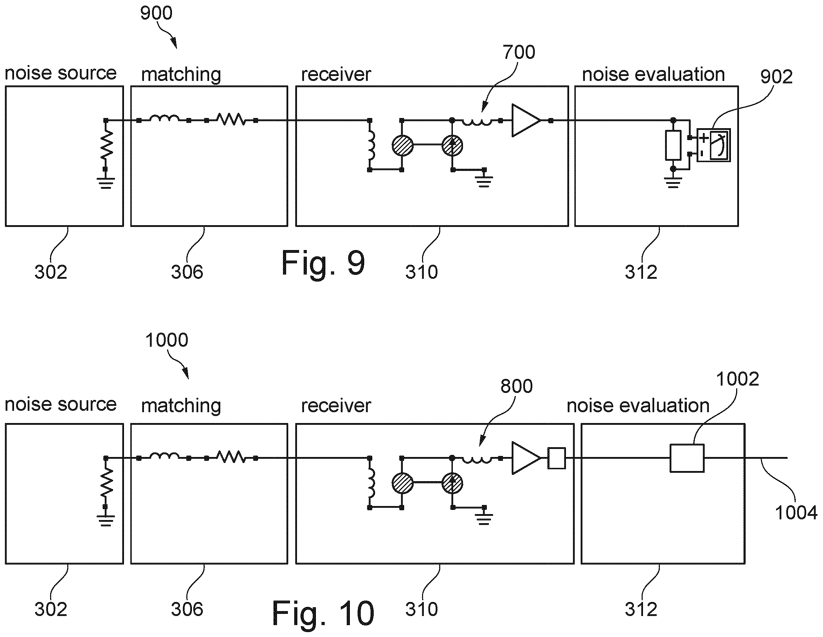

Fig. 9 illustrates an example of an analogue noise test system 900. The components of Fig. 9 may be combined with Fig. 3. Again, there is a calibrated noise source 302 which is connected to a set of calibrated matching networks 306. This in turn is connected to the circuit model of the analogue amplifier 700 which is connected to the measurement device 312. In this example the measurement device 312 comprises an analogue power meter 902.

Fig. 10 illustrates a digital noise test system 1000. The components are similar except the circuit model of the digital amplifier 800 is used and the digital output 804 is connected to a digital receiver 1002 which is able to calculate a power spectrum and then output a power level 1004.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,
Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A system (100, 900, 1000) for determining noise parameters of an amplifier, comprising a processor (104) configured to:
receive (200) calibration data (124), wherein the calibration data comprises multiple noise power measurements descriptive of output of the amplifier corresponding to a predetermined set of complex noise input signals (126); and
determine (202) a set of linear noise parameters of the amplifier by fitting the multiple noise power measurements and the corresponding set of complex noise input signals to a circuit model (122, 700, 800) of the amplifier.

2. The system of claim 1, wherein the circuit model comprises:
a first reactance (706);
a set of noise sources, wherein the set of noise sources comprises a voltage noise source (708) and a current noise source (710), wherein the voltage noise source and the current noise source are preferably correlated (712), wherein the first reactance is connected in series between an input (702) of the circuit model and the voltage noise source;
an amplifier model (716), wherein the amplifier model comprises a real valued input impedance; and
a second reactance (714) connected in series between the voltage noise source and an input of the amplifier model, wherein the current noise source is connected between a ground (718) and the second reactance where the voltage noise source is connected to the second reactance, wherein an output of the amplifier model is connected to an output of the circuit model.

3. The system of claim 2, wherein determining the set of linear noise parameters comprises adjusting values of the first reactance, the second reactance, a noise level of the voltage noise source, a noise level of the current noise source, preferably the correlation between the voltage noise source and the current noise source, and preferably a gain of the amplifier model to the corresponding predetermined set of noise input signals.

4. The system of claim 3, wherein the set of linear noise parameters comprises an optimal source impedance (604) comprising a real and an imaginary part, wherein the imaginary part of the optimal source impedance is equal to the negative first reactance, and wherein the real part of the optimal source impedance is calculated by dividing the noise level of the voltage noise source by the noise level of the current noise source.

5. The system of any one of claims 1 to 3, wherein the set of linear noise parameters comprises an optimal source impedance, a minimum noise figure, and a Lange N parameter.

6. The system of any one of the preceding claims, wherein the predetermined set of noise input signals is based on a set of noise signals generated by predetermined combination of a set of calibrated matching networks and a calibrated noise source connected in series, the noise source being preferably configured to operate at a predefined set of temperatures.

7. The system of claim 6, comprising any one of the following: the calibrated noise source, the set of calibrated matching networks, a measurement device configured to measure the multiple noise power measurements, any combinations thereof.

8. The system of claim 7, further comprising a switching network (504) configured for providing the multiple matching networks during the repeated acquisition of the multiple noise power measurements, and wherein the system preferably comprises a temperature control system (304, 308) configured for adjusting the controllable temperature between the predefined set of temperatures.

9. The system of claim 8, wherein the processor is further configured to acquire the multiple noise power measurements by repeatedly:
preferably controlling the temperature control system for adjusting the controllable temperature to one of the predefined set of temperatures;
controlling (400) the switching network to attach a different matching network selected from the multiple calibrated matching networks using the switching network; and
controlling (402) the measurement device to acquire one of the multiple noise power measurements corresponding to the different matching networks and preferably the one of the predefined set of temperatures.

10. The system of any one of claims 7 to 9, wherein the measurement device is configured to:
receive an analog signal from the amplifier; and
measure one of the multiple noise power measurements.

11. The system of claim 7 to 9, wherein the measurement device is configured to:
receive a digital signal from the amplifier;
calculate a digital noise spectrum by Fourier transforming the digital signal;
determine one of the multiple noise power measurements from a predetermined portion of the digital noise spectrum.

12. A method of determining noise parameters of an amplifier, comprising:
receiving (200) calibration data (124), wherein the calibration data comprises multiple noise power measurements descriptive of an output of the amplifier corresponding to a predetermined set of complex noise input signals (126); and
determining (202) a set of linear noise parameters of the amplifier by fitting the multiple noise power measurements and the corresponding set of complex noise input signals to a circuit model (122, 700, 800) of the amplifier.

13. The method of claim 12, wherein the circuit model comprises:
a first reactance (706);
a set of noise sources, wherein the set of noise sources comprises a voltage noise source (708) and a current noise source (710), wherein the voltage noise source and the current noise source are preferably correlated (712), wherein the first reactance is connected in series between an input (702) of the circuit model and the voltage noise source;
an amplifier model (716), wherein the amplifier model comprises a real valued input impedance; and
a second reactance (714) connected in series between the voltage noise source and an input of the amplifier model, wherein the current noise source is connected between a ground (718) and the second reactance where the voltage noise source is connected to the second reactance, wherein an output of the amplifier model is connected to an output of the circuit model.

14. The method of claim 14, wherein determining the set of linear noise parameters comprises adjusting values of the first reactance, the second reactance, a noise level of the voltage noise source, a noise level of the current noise source, the real valued input impedance, preferably the correlation between the voltage noise source and the current noise source, and preferably a gain of the amplifier model to the corresponding predetermined set of noise input signals, wherein the set of linear noise parameters comprises an optimal source impedance comprising an imaginary part and a real part, and wherein the real part of the optimal source impedance is equal to the negative first reactance, wherein the real part of the optimal source impedance is calculated by dividing the noise level of the voltage noise source by the noise level of the current noise source, wherein the amplifier is a magnetic resonance imaging pre-amplifier, wherein the method further comprises a noise calibration of a magnetic resonance imaging system coil assembly, wherein the magnetic resonance imaging system coil assembly comprises a magnetic resonance imaging coil connected to the amplifier via a matching network, wherein the method further comprises adjusting (406) an output impedance of the matching network to the optimal source impedance.

15. A computer program comprising machine executable instructions, wherein execution of the machine executable instructions causes a computational system to perform a method according to any of the claims 12 to 14.
